# EUROPÄISCHE PATENTANMELDUNG

(11) **EP 1 916 414 A2**
(43) Veröffentlichungstag der Anmeldung: **30.04.2008**
(21) Anmeldenummer: 07115062.7
(22) Anmeldetag: 28.08.2007
(51) Int. Cl.: F02M 63/00, F02M 47/02, F02M 61/16

(54) **Kraftstoffinjektor mit Piezoaktor**

(30) Priorität: 23.10.2006 DE 102006049884
(71) Anmelder: ROBERT BOSCH GMBH, 70442 Stuttgart (DE)
(72) Erfinder: Boecking, Friedrich, 70499, Stuttgart (DE)

(57) **Zusammenfassung**

Die Erfindung bezieht sich auf einen Kraftstoffinjektor (10) mit einem mindestens einen Aktor (16) zur Betätigung eines Schaltventiles (42) aufweisenden Gehäuse (14). Der Kraftstoffinjektor (10) umfasst einen Steuerraum (32), der über einen Ablaufkanal (28) druckentlastbar und über eine Hochdruckleitung (24) mit einem Systemdruck beaufschlagt ist. Der mindestens eine Aktor (16) weist einen mit mindestens einer Schwächungszone (52) versehenen Träger (48) auf. An dessen Umfang sind Lagen von Piezoschichten (46) konzentrisch aufgenommen.

## Beschreibung

### Stand der Technik

EP 1 612 403 A1 bezieht sich auf ein Servoventil zur Steuerung eines Kraftstoffinjektors für eine Verbrennungskraftmaschine. Der Kraftstoffinjektor umfasst ein äußeres Gehäuse, welches eine Düse umfasst, über welche Kraftstoff in einen Zylinder der Verbrennungskraftmaschine eingespritzt wird. Innerhalb des Gehäuses befindet sich ein Ventilelement, welches in axiale Richtung verschiebbar ist und das die Bewegung des Einspritzventilgliedes steuert. Im Gehäuse ist des Weiteren ein Servoventil zur Steuerung aufgenommen. Dem Servoventil ist ein Betätigungselement in Form eines Magnetventils zugeordnet. Der Kraftstoffinjektor umfasst des Weiteren einen Steuerraum, der mit einem Kraftstoffeinlass und einem Kraftstoffauslass in Verbindung steht, wobei der Kraftstoffauslass einen kalibrierten Abschnitt aufweist und der Druck im Steuerraum die axiale Bewegung des Einspritzventilgliedes steuert. An einem Ankerbolzen des Magnetventils ist ein hülsenförmiges Bauteil (Shutter) aufgenommen, welcher in Längsrichtung durch das Magnetventil bewegbar ist. Die Bewegung verläuft zwischen einer vollständig geschlossenen Position, in welcher der Kraftstoffauslass verschlossen ist, und einer vollständig geöffneten Position, in welcher der Kraftstoffauslass offen steht, so dass der Druck innerhalb des Steuerraumes derart geändert werden kann, dass die Düse des Kraftstoffinjektors verschlossen und geöffnet werden kann. Das Servoventil zur Steuerung des Kraftstoffinjektors umfasst des Weiteren einen Ankerbolzen, der in Bezug auf das Gehäuse in einer stationären Position angeordnet ist. Bei dem aus EP 1 612 403 A1 offenbarten Kraftstoffinjektor mündet der Kraftstoffauslass in einer äußeren Oberfläche des feststehenden Ankerbolzens. Das hülsenförmige, den stationären Ankerbolzen umschließende Bauteil (Shutter) ist derart ausgebildet, dass es sich an einer seitlichen Oberfläche verschiebbar und eine Abdichtwirkung erzeugend bewegt. In der vollständig geschlossenen Position wird durch das hülsenförmige Bauteil der Kraftstoffauslass verschlossen, so dass eine resultierende Axialkraft, hervorgerufen durch den Kraftstoffdruck, den Wert 0 annimmt.

Bei Betätigung von Kraftstoffinjektoren mittels eines Magnetventils, wie in EP 1 612 403 A1 dargestellt, lassen sich in vorteilhafter Weise geringe Schaltkräfte bei hohen Drücken realisieren. Von Nachteil bei Magnetventilen ist jedoch die Dynamik des Magneten, gegeben z. B. durch das Ankerprellen oder ein unerwünschtes "Kleben" der Ankerplatte am Elektromagnetteil des Magnetventils.

### Offenbarung der Erfindung

Erfindungsgemäß wird vorgeschlagen, zur Betätigung eines Kraftstoffinjektors einen Aktor, insbesondere einen Piezoaktor, einzusetzen, bei dem die einzelnen Piezokristallschichten einige wenige Lagen konzentrisch zueinander angeordneter kreisrunder Piezoschichten umfassen. Die wenigen Lagen kreisrunder Piezokristallschichten werden auf einen Träger aufgebracht. Die im Wesentlichen in vertikaler Lage konzentrisch zueinander in Bezug auf den Träger angeordneten, wenigen Lagen von Piezoschichten dehnen sich in Querrichtung in Bezug auf den Träger aus und ziehen sich in Längsrichtung bezogen auf den die wenigen Lagen Piezoschichten aufnehmenden Träger zusammen. Der Träger kann in vorteilhafter Weise als eine Trägerhülse ausgebildet sein, die sich an einem Ende auf einem Ausgleichskolben abstützt, der im Kopfbereich eines Gehäuseteils des Kraftstoffinjektors angeordnet ist, und ist mit seinem anderen Ende fest mit einem Ventilkolben eines Schaltventils verbunden.

Bevorzugt weist der die wenigen Lagen konzentrisch zueinander angeordneten Piezokristallschichten aufnehmende Träger einen dem Piezoaktor ähnlichen, bevorzugt identischen Wärmeausdehnungskoeffizienten auf. Ein sich gegebenenfalls einstellender Unterschied in Bezug auf den Wärmeausdehnungskoeffizienten des Gehäusematerials des Gehäuses, in welchem Träger und Piezoaktor aufgenommen sind, wird über einen Ausgleichskolben, dem ein hydraulisches Polster zugeordnet ist, gegebenenfalls ausgeglichen.

Bei Betätigung des Piezoaktors zieht dieser aufgrund des bei Bestromung der wenigen Lagen kreisrunder Piezoschichten auftretenden Zusammenziehens des Piezoaktors den mit diesem fest verbundenen Ventilkolben des kraftausgeglichen ausgeführten Schaltventils auf. Die Kraftausgeglichenheit des Schaltventils ist dadurch gegeben, dass der Sitzdurchmesser des Ventiles dem Führungsdurchmesser des Ventilelementes entspricht. Wird der im Schaltventil vorhandene Sitz beim Zusammenziehen des Piezoaktors mit wenigen Lagen in vertikaler Richtung orientierter Piezoschichten geöffnet, so wird ein Ablaufkanal eines Steuerraums druckentlastet. Im Ablaufkanal, der durch den geöffneten Sitz des Schaltventiles druckentlastet wird, ist im Abströmbereich am Steuerraum eine Ablaufdrossel vorgesehen.

Die Befüllung des Steuerraums erfolgt über einen Hochdruckzulauf, wobei an der Eintrittsstelle des Hochdruckzulaufs in den Steuerraum bevorzugt mindestens eine Zulaufdrossel angeordnet ist.

Bei dieser Ausführungsvariante des erfindungsgemäß vorgeschlagenen Kraftstoffinjektors ist eine optimale Wärmeausgleichskompensation erreichbar. Des Weiteren kann in vorteilhafter Weise die Schließfeder des Ventiles im Kopfbereich des Aktors in das hydraulische Polster integriert werden, so dass die Bauhöhe des erfindungsgemäß vorgeschlagenen Kraftstoffinjektors in einer ersten Ausführungsvariante klein gehalten werden kann.

In einer zweiten Ausführungsvariante des erfindungsgemäß vorgeschlagenen Kraftstoffinjektors ist das Schaltventil als kraftausgeglichenes Ventil ausgebildet. Das Ventilelement des kraftausgeglichen ausgebildeten Schaltventiles ist mit einem Piezoaktor verbunden, bei dem es sich um einen Piezoaktor handelt, bei dem eine Anzahl weniger Lagen von Piezokristallschichten im Wesentlichen vertikal orientiert konzentrisch zueinander an einem Träger ausgebildet sind. Die Piezokristallschichten werden z. B. mit dem Träger verklebt. Bei dem Träger handelt es sich bevorzugt um ein flexibles Bauelement, welches den Hub des Piezoaktors auf das Ventilelement des kraftausgeglichenen Schaltventiles überträgt. Im Gegensatz zu bisher eingesetzten Piezoaktoren ist aufgrund der Orientierung der wenigen Lagen von Piezokristallschichten im Wesentlichen in vertikale Richtung, der erfindungsgemäß vorgeschlagene Piezoaktor nicht vorzuspannen. Der Träger weist bevorzugt einen ähnlichen Wärmeausdehnungskoeffizienten wie der eingesetzte Piezoaktor auf und wird z. B. aus einem Material wie Invar hergestellt.

Bei Betätigung des Piezoaktors, d. h. Bestromung der wenigen Lagen von im Wesentlichen in vertikaler Richtung orientierten Piezoschichten, zieht sich der Piezoaktor zusammen und zieht das Ventilelement des Schaltventiles auf, d. h. öffnet den im Schaltventil vorgesehenen Sitz. Ein eventuell verbleibender Restfehler im Hinblick auf die Wärmeausdehnungskoeffizienten des Piezoaktors und das diese umgebende Gehäuse im Kopfbereich des Kraftstoffinjektors kann z. B. über einen Vorhub am Schaltventil kompensiert werden. Der Vorhub kann z. B. dadurch realisiert werden, dass eine z. B. als U-Scheibe ausgebildete Scheibe am Träger der wenigen Lagen von Piezokristallschichten aufgenommen ist, die in einen ein Axialspiel der U-Scheibe ermöglichenden Schlitz im Ventilelement eingreift.

Bevorzugt wird das den Piezoaktor umschließende Gehäuse ebenfalls aus Invar gefertigt, um die Wärmeausdehnungskoeffizienten zu berücksichtigen.

Bei Bestromung des wenige Lagen von Piezokristallschichten in vertikaler Orientierung angeordnet umfassenden Piezoaktors zieht sich dieser zusammen, so dass die vom Piezoaktor umschlossene Hülse schrumpft und nach Überwindung des Vorhubs das Ventilelement relativ zu einem in der zweiten Ausführungsvariante stationär angeordneten Kolben aufzieht, so dass der Sitz des Schaltventiles öffnet. Dadurch wird eine Druckentlastung des Steuerraums erreicht, wobei sich in der zweiten Ausführungsvariante der Ablaufkanal im Wesentlichen durch das Innere des stationär im Kraftstoffinjektor angeordneten Kolbens erstreckt. Der Steuerraum wird analog zur ersten Ausführungsvariante des erfindungsgemäß vorgeschlagenen Kraftstoffinjektors über einen Hochdruckzulauf befüllt, wobei zwischen der Mündungsstelle des Hochdruckzulaufes und dem Eintritt des Steuerraums bevorzugt mindestens eine Zulaufdrossel vorgesehen ist. Je nachdem, in welcher Baulänge das im Kopfbereich des Kraftstoffinjektors angeordnete Gehäuse ausgeführt ist, kann entsprechend der Baulänge ein wärmebedingter Ausdehnungsfehler zwischen Piezoaktor und Träger und dem diese umschließenden Gehäuse reduziert werden, wobei ein gegebenenfalls verbleibender Restfehler durch den Vorhub ausgeglichen wird.

Der mit der zweiten Ausführungsvariante erzielbare Vorteil ist darin zu erblicken, dass auf einen Hubübersetzer für den Piezoaktor verzichtet werden kann. Bevorzugt wird der Träger, welcher die wenigen Lagen von im Wesentlichen in vertikaler Richtung orientierten Piezoschichten aufnimmt, als eine geschlitzte Hülse oder ein gewelltes Rohr ausgebildet. Das Material des Trägers, der die wenigen Lagen von in vertikaler Richtung orientierten Piezoschichten aufnimmt, wird durch Schlitzungen beziehungsweise Wellungen so geschwächt, dass der Piezoaktor beim Zusammenziehen die Steifigkeit des Trägers mit überwindet.

In einer dritten Ausführungsvariante des erfindungsgemäß vorgeschlagenen Kraftstoffinjektors ist dieser analog zu den oben erwähnten Ausführungsvarianten mit einem kraftausgeglichen ausgeführten Schaltventil versehen. Bei der dritten Ausführungsvariante des Kraftstoffinjektors zur Betätigung mittels eines Piezoaktors ist der die wenigen Lagen aufnehmende Träger so ausgebildet, dass dieser mit einem Übergriff versehen ist und das Ventilelement des kraftausgeglichen ausgebildeten Schaltventiles aufzieht. Bei der dritten Ausführungsvariante können auf dem die wenigen Lagen von Piezoschichten in vertikaler Ausrichtung aufnehmenden Träger mehrere Piezoaktoren verwirklicht werden. Diese sind bevorzugt symmetrisch am Umfang des Trägers eingebaut. Durch die Trägerauslegung wird der Piezoaktor mechanisch stabilisiert und gewährleistet, dass das bei Bestromung des mindestens einen Piezoaktors gemäß dieser Ausführungsvariante auftretende Zusammenziehen des Piezoaktors an das Ventilelement übertragen wird. Auch in der dritten Ausführungsvariante des erfindungsgemäß vorgeschlagenen Kraftstoffinjektors ist der Träger mit Schlitzungen oder z. B. Wellungen versehen, um ein Zusammenziehen des Trägers bei Bestromung der wenigen Lagen von im Wesentlichen in vertikaler Richtung orientierten Piezokristallschichten zu ermöglichen.

Auch gemäß der dritten Ausführungsvariante wird der Träger aus einem Material wie z. B. Invar gefertigt, um die wärmebedingten Dehnungen des Aktors zu kompensieren. Eventuell verbleibende Restfehler hinsichtlich einer unterschiedlichen Wärmedehnung zwischen dem Träger und dem Schaltventil werden mittels eines Vorhubs von wenigen µm ausgeglichen. Der Vorhub ist durch eine Toleranz zwischen dem Ventilelement und dem dieses übergreifenden unteren Ende des Trägers realisiert.

Eine Einstellung des Vorhubs kann über eine Einstellscheibe realisiert werden.

Der mit der dritten Ausführungsvariante des erfindungsgemäß vorgeschlagenen Kraftstoffinjektors einhergehende Vorteil liegt in der Kombination eines einfach bauenden Piezoaktors in Kombination mit einem kraftausgeglichenen Schaltventil. Die dem Piezoaktor innewohnende Dynamik lässt sich trotz der kleinen mit dem Piezoaktor erzeugbaren Kräfte zur Betätigung des Schaltventiles nutzen.

### Zeichnung

Anhand der Zeichnung wird die Erfindung nachstehend eingehender beschrieben.

Es zeigt:
- Figur 1: eine erste Ausführungsvariante des erfindungsgemäß vorgeschlagenen Kraftstoffinjektors mit einem kolbenförmig ausgebildeten Ventilelement am Schaltventil,
- Figur 2: eine zweite Ausführungsvariante des erfindungsgemäß vorgeschlagenen Kraftstoffinjektors, bei dem das Ventilelement glockenförmig ausgebildet ist und mittels des Piezoaktors relativ zu einem stationär im Kraftstoffinjektor angeordneten Kolben bewegt wird,
- Figur 3: eine dritte Ausführungsvariante des erfindungsgemäß vorgeschlagenen Kraftstoffinjektors, in welchem der die wenigen Piezokristallschichten des Piezoaktors aufnehmende Träger das Ventilelement des Schaltventiles unter Ausbildung eines Vorhubs umgreift und
- Figur 3.1: eine Darstellung des Trägers in vergrößertem Maßstab.

### Ausführungsvarianten

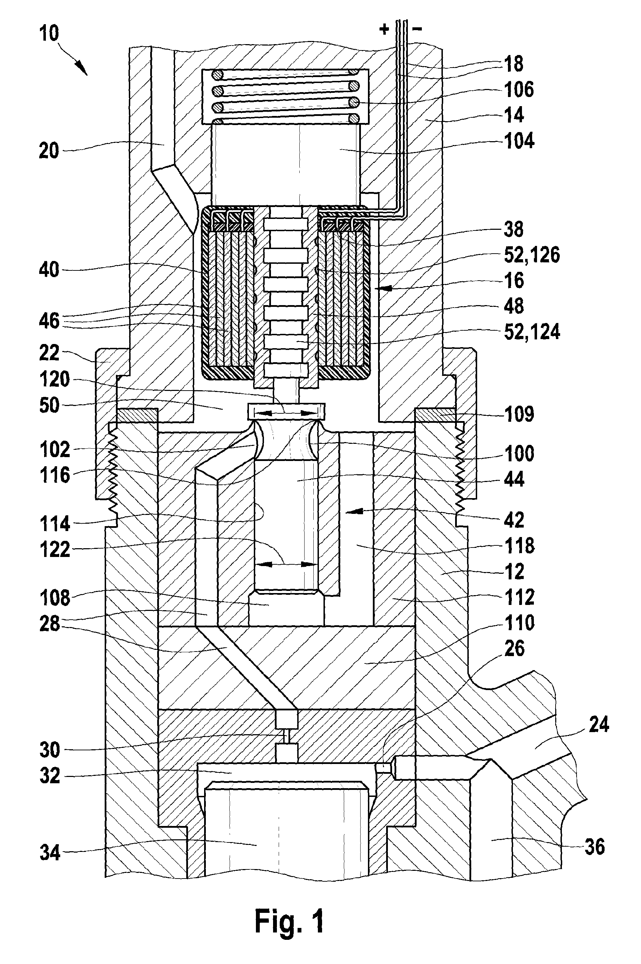

Die Figuren 1 bis 3 zeigen Ausführungsvarianten eines Kraftstoffinjektors 10, der einen Injektorkörper 12 umfasst. Im oberen Bereich des Injektorkörpers 12 befindet sich ein Aufsatzgehäuse 14, welches aus einem Material wie z. B. Invar gefertigt wird, und welches einen Aktor 16, insbesondere einen Piezoaktor 16, umschließt. Der Piezoaktor 16 wird über elektrische Anschlüsse 18 mit einer Spannungsquelle verbunden, über diese geladen oder entladen und erfährt eine Dehnung zum Beispiel in eine erste Richtung. In eine senkrecht zur ersten Richtung orientierte zweite Richtung zieht sich der Piezoaktor 16 hingegen zusammen und bleibt volumenkonstant. Im Aufsatzgehäuse 14 des Kraftstoffinjektors 10 befindet sich ein Leckölablauf 20, über den Lecköl in den Niederdruckbereich des Kraftstoffmjektors 10 abströmt.

Das Aufsatzgehäuse 14 wird z. B. über eine Spannmutter 22 mit dem Injektorkörper 12 verbunden und auch über die Spannmutter 22 abgedichtet. Seitlich in den Injektorkörper 12 mündet ein Hochdruckzulauf 24 (CR-Zulauf), der an einen Hochdruckspeicherkörper (Common Rail) eines Hochdruckspeichereinspritzsystems angeschlossen ist. Der Hochdruckzulauf 24 vom nicht dargestellten Hochdruckspeicherkörper mündet in den nachfolgend wiedergegebenen Ausführungsvarianten des erfindungsgemäß vorgeschlagenen Kraftstoffinjektors 10 in einen Steuerraum 32. Vor Eintritt des Hochdruckzulaufes 24 in den Steuerraum 32 befindet sich im Hochdruckzulauf 24 mindestens eine Zulaufdrossel 26. Der im Injektorkörper 12 ausgebildete Steuerraum 32 ist über einen Ablaufkanal 28 druckentlastbar. Im Ablaufkanal 28 befindet sich unmittelbar in Abströmrichtung des Kraftstoffes aus dem Steuerraum 32 gesehen, mindestens eine Ablaufdrossel 30, wobei der Ablaufkanal 28 innerhalb eines scheibenförmigen Einsatzes 110 verläuft.

Des Weiteren verläuft im Injektorkörper 12 des Kraftstoffinjektors 10 ein Düsenzulauf 36, der sich zum brennraumseitigen Ende des Kraftstoffinjektors 10 erstreckt. Der Düsenzulauf 36 mündet im Injektorkörper 12 in einen Düsenraum, der mindestens einer Einspritzöffnung vorgeschaltet ist und durch ein Einspritzventilglied 34, welches bevorzugt nadelförmig ausgebildet ist, geöffnet oder geschlossen wird. Zur elektrischen Kontaktierung des Piezoaktors 16 mit den elektrischen Anschlüssen 18 ist am Piezoaktor 16 eine Aktorkontaktierung 38 vorgesehen, in welcher die elektrischen Anschlüsse 18 z. B. vergraben sind und elektrisch isoliert werden.

Der Piezoaktor 16, wie er bei den nachfolgend skizzierten Ausführungsvarianten gemäß der Figuren 1 bis 3 eingesetzt wird, ist von einer Isolation 40 umschlossen, mit welcher der Piezoaktor 16 im Niederdruckbereich des Kraftstoffinjektors 10 gegen das dort herrschende Druckniveau geschützt wird. Über den Piezoaktor 16 wird ein bevorzugt kraftausgeglichen ausgebildetes Schaltventil 42 betätigt, welches ein Ventilelement 44 aufweist, das entweder in Form eines Kolbens ausgebildet werden kann oder auch eine glockenförmige Ausführung aufweisen kann, die relativ zu einem stationär im Kraftstoffinjektor angeordneten Kolben bewegt werden kann.

Der in den Figuren 1 bis 3 dargestellte Piezoaktor 16 ist ein solcher, bei welchem wenige Lagen von ringförmig ausgebildeten Piezoschichten 46 z. B. in Multilayertechnik oder in Klebetechnik an einem im Wesentlichen hülsenförmig ausgebildeten Träger 48 aufgenommen sind. Die wenigen Lagen von Piezoschichten 46 umschließen einander kreisförmig und bewirken bei Bestromung der Piezoschichten 46 ein Zusammenziehen des Piezoaktors 16 in axiale Richtung und damit ein Zusammenziehen des im Wesentlichen hülsenförmig ausgebildeten Trägers 48. Aus den nachfolgend noch detaillierter beschriebenen Ausführungsvarianten des erfindungsgemäß vorgeschlagenen Kraftstoffinjektors 10 geht hervor, dass die wenigen Lagen von Piezoschichten 46 im Wesentlichen in vertikaler Orientierung angeordnet sind. Bei Bestromung des Piezoaktors 10 über die Aktorkontaktierung 38, an der die elektrischen Anschlüsse angeschlossen sind, dehnen sich die wenigen Lagen von Piezoschichten in radiale Richtung aus, ziehen sich hingegen in axiale Richtung in Bezug auf die Symmetrieachse des Trägers 48 zusammen. Der Träger 48 ist in einem vom Aufsatzgehäuse 40 umschlossenen Hohlraum 50 aufgenommen, in welchem bei Betätigung des Schaltventils 42 Steuermenge aus dem Steuerraum 32 über den Ablaufkanal 28 eintritt. Im Hohlraum 50, in dem sich der Piezoaktor 16 befindet, herrscht demnach Niederdruckniveau, welchem der Piezoaktor 16 ausgesetzt ist. Da sich die wenigen Lagen von in vertikaler Orientierung angebrachten Piezoschichten 46 bei Bestromung des Piezoaktors 16 über die elektrischen Kontakte 18 in Bezug auf den Träger 48 in axiale Richtung zusammenziehen, ist der Träger 48 entweder geschlitzt oder gewellt ausgebildet, so dass die Kontraktionsbewegung der wenigen Lagen von Piezoschichten 46 an den Träger 48 übertragen wird. Der Träger 48 seinerseits ist mit dem Ventilelement 44 des Schaltventils 42 verbunden, welches entweder kolbenförmig oder auch topf- beziehungsweise glockenförmig ausgebildet sein kann. Über die Kontraktionsbewegung der wenigen Lagen von Piezoschichten 46 des Piezoaktors 16 wird das Ventilelement 44 aus seinem Sitz im Schaltventil 42 bewegt oder wieder in diesen gestellt, so dass das Schaltventil 42 geschlossen wird.

Aus der Darstellung gemäß Figur 1, die die erste Ausführungsvariante des erfindungsgemäß vorgeschlagenen Kraftstoffinjektors 10 darstellt, geht hervor, dass der Träger 48 als Hülse ausgebildet ist. Am hülsenförmig ausgebildeten Träger 48 ist mindestens eine Schwächungszone 52 ausgeführt, die am Innenumfang und am Außenumfang des Trägers 48 verläuft. In der Darstellung gemäß Figur 1 befinden sich am Außenumfang des Trägers 48 in axiale Richtung voneinander beabstandet einzelne Außennuten 126, die z. B. gerundet ausgeführt sind, und am Innenumfang des hülsenförmig ausgebildeten Trägers 48 eine Anzahl von in axialer Richtung voneinander beabstandeter Innennuten 124, die eine rechteckförmige Konfiguration aufweisen. In Figur 1 ist erkennbar, dass die Außennuten 126 und die Innennuten 124 in axialer Richtung in Bezug auf den Träger 48 versetzt zueinander angeordnet sind. Figur 1 zeigt ferner, dass eine Anzahl von wenigen Lagen von Piezoschichten 46 konzentrisch in Bezug auf den hülsenförmig ausgebildeten Träger 58 angeordnet sind. Die wenigen Lagen von Piezoschichten 46 werden über die Aktorkontaktierung 38 mit den elektrischen Anschlüssen 18 kontaktiert. Der von einer Isolation 40 umschlossene Aktor 16 stützt sich an einem Ausgleichskolben 104 ab, der seinerseits von einer Kolbenfeder 106 beaufschlagt ist, die sich wiederum an einer Planfläche des Gehäuses 14 abstützt. Im Gehäuse 14 verläuft der Leckölablauf 20 in den Niederdruckbereich des Kraftstoffinjektors. Das Gehäuse 14 ist mit dem Injektorkörper 12 des Kraftstoffinjektors 10 unter Zwischenschaltung einer Einstellscheibe 109 mittels einer Spannmutter 22 dichtend verbunden.

Die wenigen Lagen von konzentrisch zum hülsenförmigen Träger 48 angeordneten Piezoschichten 46 dehnen sich bei Bestromung des Aktors 16 quer in Bezug auf den Träger 48 und kontrahieren sich in Längsrichtung des Trägers 48, d. h. in axialer Richtung. Das Material, aus dem der Träger 48 gefertigt ist, weist bevorzugt einen Wärmeausdehnungskoeffizienten auf, der dem Wärmeausdehnungskoeffizienten des Materials der Piezoschichten 46 entspricht. Ein Unterschied zwischen dem Wärmeausdehnungskoeffizienten gegenüber dem Gehäuse 14 kann mittels des Ausgleichskolbens 104 ausgeglichen werden, wobei die Ventilfeder 106 in einem hydraulischen Raum des Gehäuses 14 aufgenommen werden kann, in welchem ein als hydraulisches Polster dienender Fluidvorrat bevorratet wird.

Aus der Darstellung gemäß Figur 1 geht hervor, dass der Träger 48 einen Zapfen des in der Darstellung gemäß Figur 1 kolbenförmig ausgebildeten Ventilelementes 44 umschließt und mit diesem fest verbunden ist. Am Umfang des kolbenförmig ausgebildeten Ventilelementes 44 befindet sich eine Ausnehmung 100 unterhalb eines Sitzes 116. Im Bereich der ringförmig am Umfang des Ventilelementes 44 ausgebildeten Ausnehmung 100 liegt eine Mündungsstelle 102 des Ablaufkanals 28 vom Steuerraum 32. Das in der Darstellung gemäß Figur 1 kolbenförmig ausgebildete Ventilelement 44 weist einen Sitzdurchmesser 120 und einen Führungsdurchmesser 122 auf, die bevorzugt einander entsprechen, so dass das Ventilelement 44 des Schaltventiles 42 kraftausgeglichen ist.

Das in der ersten Ausführungsvariante kolbenförmig ausgebildete Ventilelement 44 ist mit seinem Führungsdurchmesser 122 in einem topfförmigen Einsatz 112 bewegbar, der eine im Führungsdurchmesser 122 ausgeführte Bohrung 114 aufweist. Der am oberen Ende des kolbenförmig ausgebildeten Ventilelementes 44 ausgebildete Sitz 116 wird bei Bestromung des Piezoaktors 16 und dessen Kontraktion in axiale Richtung geöffnet und bei Aufhebung der Bestromung des Piezoaktors 16 aufgrund der Wirkung der innerhalb eines hydraulischen Polsters angeordneten Kolbenfeder 106 wieder geschlossen. Unterhalb der dem Sitz 116 abgewandten Stirnseite des kolbenförmig ausgebildeten Ventilelementes 44 befindet sich ein hydraulischer Raum 108, der in eine Leckölleitung 118 übergeht, die ihrerseits in den Hohlraum 50 innerhalb des Gehäuses 14 mündet.

Bei Bestromung der Lagen von konzentrisch zueinander am Umfang des Trägers 48 geschichtet aufgenommenen Piezoschichten 46 ziehen sich diese in axiale Richtung zusammen, so dass der mit mindestens einer Schwächungszone 52 ausgebildete Träger 48 das kolbenförmig ausgebildete Ventilelement 44 aus einem Sitz 116 zieht. Dadurch strömt eine Steuermenge vom Steuerraum 32 über die Ablaufdrossel 30, den Ablaufkanal 28 und die Mündungsstelle 102 in den Hohlraum 50 ein. Das bevorzugt nadelförmig ausgebildete Einspritzventilglied 34 fährt in den Steuerraum 32 auf und gibt am brennraumseitigen Ende des Kraftstoffinjektors 10 ausgebildete Einspritzöffnungen frei, die über den Düsenzulauf 36, der vom Hochdruckzulauf 24 abzweigt, mit unter Systemdruck stehendem Kraftstoff beaufschlagt sind.

Bei Aufhebung der Bestromung des Piezoaktors 16 wird der Träger 48 durch die Wirkung der Ventilfeder 106 wieder auf seine ursprüngliche Länge gestaucht, so dass das mit dem Träger 48 verbundene Ventilelement 44 wieder in den Sitz 116 gestellt wird und diesen verschließt. Dadurch ist die Mündungsstelle 102 des Ablaufkanals 28 verschlossen, so dass sich im Steuerraum 32, der über den Hochdruckzulauf 24 druckbeaufschlagt ist, wieder Systemdruck einstellt und das geöffnete Einspritzventilglied 34 wieder in seine Schließstellung überführt wird.

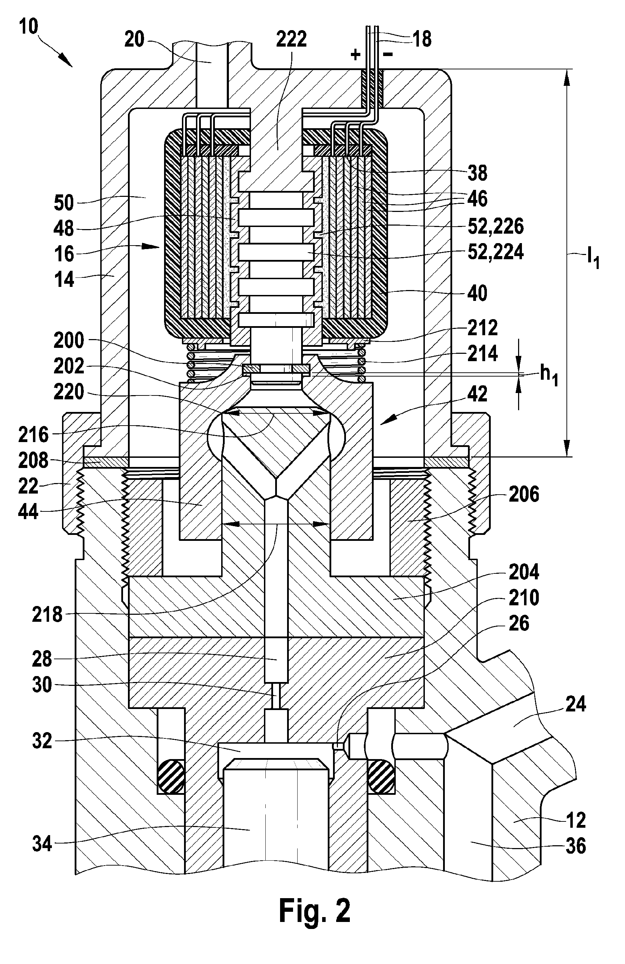

Der Darstellung gemäß Figur 2 ist die zweite Ausführungsvariante des erfindungsgemäß vorgeschlagenen Kraftstoffinjektors 10 zu entnehmen. Aus der Darstellung gemäß Figur 2 geht hervor, dass am Träger 48, der auch gemäß dieser Ausführungsvariante hülsenförmig ausgebildet ist, ein Zapfen ausgeführt ist, an dessen Umfang ein bevorzugt als U-Scheibe ausgebildetes Mitnahmeelement 200 aufgenommen ist. Der Träger 48 ist an einem Gehäusezapfen 222 an der Oberseite des Gehäuses 14 aufgenommen, dessen Länge mit 1₁ bezeichnet ist. Dieses bewegt sich in einer ringförmigen, im oberen Bereich des in der Ausführungsvariante gemäß Figur 2 glockenförmig ausgebildeten Ventilelementes 44 ausgebildeten Ausnehmung, die durch Bezugszeichen 202 identifiziert ist. Zwischen einem stationär im Kraftstoffinjektor mittels einer Spannschraube 206 befestigten stationären Kolben 204 und der Innenseite des glockenförmig ausgebildeten Ventilelementes 44 ist ein Sitz 220 ausgebildet. Auch das in der Ausführungsvariante gemäß Figur 2 dargestellte Schaltventil 42 ist kraftausgeglichen, da ein Sitzdurchmesser 216 des Sitzes 220 einem Führungsdurchmesser 218 des stationären Kolbens 204 entspricht. Über die Spannschraube 206 ist der stationäre Kolben 204 im Injektorkörper 12 des Kraftstoffinjektors 10 befestigt.

Der am Zapfen des Trägers 48 aufgenommene Mitnehmer, bevorzugt in Form einer U-Scheibe 200 ausgebildet, ist in der ringförmigen Ausnehmung 202 im glockenförmig ausgeführten Ventilelement 44 um einen Vorhubweg h₁ bewegbar, wobei der Vorhubweg h₁ durch eine Einstellscheibe 208 eingestellt werden kann, die im Bereich der Spannmutter 22 zwischen dem Gehäuse 14 und dem Injektorkörper 12 eingespannt ist. Unterhalb des von der Isolation 40 umgebenen Aktors 16 befindet sich eine Stützscheibe 212, an der sich eine Feder 214 abstützt, die das Ventilelement 44 in seine Schließstellung drängt.

Auch der in Figur 2 dargestellte, hülsenförmig ausgebildete Träger 48 umfasst an seinem Umfang bevorzugt an Innen- und Außenseite mindestens eine Schwächungszone 52. In der in Figur 2 dargestellten Ausführungsvariante des die konzentrischen Piezoschichten 46 aufnehmenden Trägers ist die mindestens eine Schwächungszone 52 als am Außen- und am Innenumfang des Trägers 48 ausgebildete Innennut- und Außennutanordnung 224, 226 beschaffen. Die mindestens eine Schwächungszone 42 verleiht dem Träger 48 die notwendigen Kontraktionseigenschaften, so dass dieser bei Bestromung der wenigen Lagen von Piezoschichten 46 die in diesen auftretende Kontraktion übernimmt und nach Überwindung des Vorhubes h₁ an das in der Darstellung gemäß Figur 2 glockenförmig ausgebildete Ventilelement 44 überträgt.

Die mindestens eine Schwächungszone 52 des Trägers 48 kann sowohl nur an dessen Außenumfang oder auch nur an dessen Innenumfang oder - wie in Figur 2 dargestellt - sowohl an Außen- und auch an Innenumfang des hülsenförmig ausgebildeten Trägers 48 ausgeführt werden. Anstelle des in Figur 2 dargestellten rechteckförmigen Querschnittes der Innennuten 224 beziehungsweise der Außennuten 226 ist auch eine dreieckförmige, eine gerundete oder jede andere beliebige Kontur der mindestens einen Schwächungszone 52 denkbar. Die Innennuten 224 und die Außennuten 226 können - wie in Figur 2 dargestellt, in axialem Versatz in Bezug auf die Axialerstreckung des hülsenförmig ausgebildeten Trägers 48 ausgebildet sein oder auch einander im Material des hülsenförmig ausgebildeten Trägers 48 gegenüberliegend ausgeführt sein.

Bevorzugt wird der hülsenförmig ausgebildete Träger 48 aus einem Material gefertigt, welches einen Wärmeausdehnungskoeffizienten aufweist, der dem Wärmeausdehnungskoeffizienten des Materials der konzentrisch umeinander angeordneten Piezoschichten 46 des Aktors 16 entspricht, wie z. B. Invar. Da der Vorhub h₁ vor dem Öffnen des Sitzes 220 des Schaltventiles 42 zu überwinden ist, kann durch den Vorhub h₁ ein gegebenenfalls verbleibender Restfehler aufgrund unterschiedlicher Wärmeausdehnungskoeffizienten zwischen dem hülsenförmig ausgebildeten Träger 48 und dem diesen umgebenden Gehäuses 14 realisiert werden. Auch das Gehäuse 14 wird bevorzugt aus einem Material wie z. B. Invar gefertigt.

Wird der Aktor 16 über die elektrischen Anschlüsse 18 mit einer Spannungsquelle verbunden, so ziehen sich die wenigen Lagen von Piezoschichten 46, die in vertikaler Orientierung in Bezug auf den hülsenförmig ausgebildeten Träger 48 angeordnet sind, in axialer Richtung zusammen. Aufgrunddessen wird das in der Darstellung gemäß Figur 2 glockenförmig ausgebildete Ventilelement 44 aus dem Sitz 116 des Schaltventils 42 gezogen, sobald der Vorhubweg h₁ zum Ausgleich von Wärmedehnungsdifferenzen überwunden ist. Da der Sitz 220 nun geöffnet ist, strömt eine Steuermenge aus dem Steuerraum 32 über die Ablaufdrossel 30 des Ablaufkanals 28 und den geöffneten Sitz 220 in den niederdruckseitigen Hohlraum 50 ab und von diesem über die Leckölleitung 20 einem Kraftstoffreservoir zu.

Der Ablaufkanal 28 verläuft gemäß der in Figur 2 dargestellten Ausführungsvariante zum Teil durch den mit der Spannschraube 206 im Injektorkörper 12 fixierten stationären Kolben 204 und zum Teil durch ein Ventilstück 210, innerhalb dessen der Steuerraum 32 ausgebildet ist und die Ablaufdrossel 30 ausgeführt ist. Ist der Sitz 220 des Schaltventils 42 geöffnet, strömt aus dem Steuerraum 32 die Steuermenge ab, so dass das bevorzugt nadelförmig ausgebildete Einspritzventilglied 34 öffnet. Dabei werden Einspritzöffnungen am in Figur 2 nicht dargestellten brennraumseitigen Ende des Kraftstoffinjektors 10 freigegeben, an denen unter Systemdruck stehender Kraftstoff, zugeführt über den Düsenzulauf 36, ansteht, der nunmehr in den Brennraum der Verbrennungskraftmaschine eingespritzt werden kann.

Bei Aufhebung der Bestromung der wenigen Lagen von konzentrischen Piezoschichten 46 des Aktors 16 wird das in Figur 2 glockenförmig ausgebildete Ventilelement 44 aufgrund der Wirkung der Feder 214, die sich an der Stützscheibe 212 unterhalb der Isolation 40 des Piezoaktors 16 abstützt, wieder in den Sitz 220 gedrückt. Dadurch wird der Sitz 220 geschlossen und die Druckentlastung des Steuerraums 32 über den Ablaufkanal 28 mit Ablaufdrossel 30 beendet. Im Steuerraum 32, der über den Hochdruckzulauf 24 mit unter Systemdruck stehendem Kraftstoff beaufschlagt ist, baut sich Systemdruck auf, welcher das nadelförmig ausgebildete Einspritzventilglied 34 beaufschlagt und dieses wieder in seinen in Figur 2 nicht dargestellten brennraumseitigen Sitz stellt, so dass die zuvor freigegebenen Einspritzöffnungen verschlossen werden.

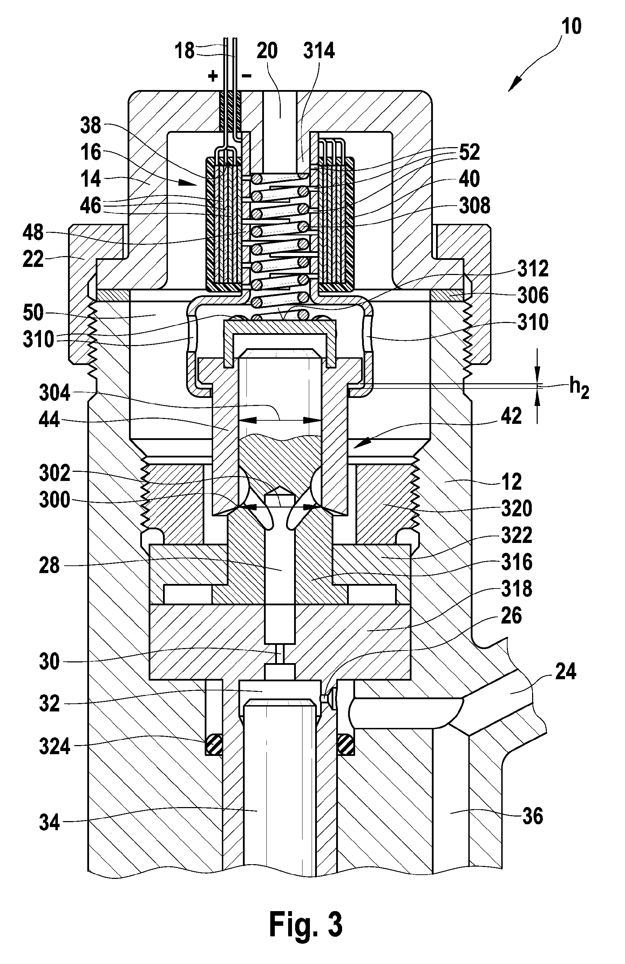

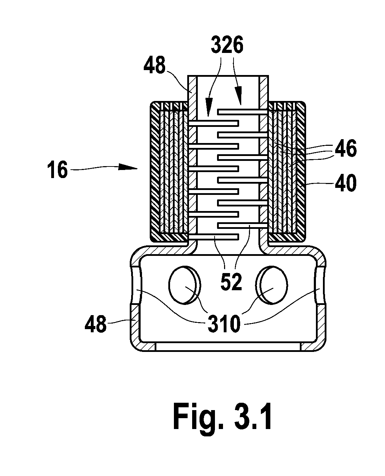

Figur 3 zeigt eine dritte Ausführungsvariante des erfindungsgemäß vorgeschlagenen Kraftstoffinjektors.

Aus der Darstellung gemäß Figur 3 geht hervor, dass mindestens ein Aktor 16 am Umfang des hülsenförmig ausgebildeten Trägers 48 ausgeführt ist. Auch in der in Figur 3 dargestellten Ausführungsvariante des Trägers 48 weist dieser mindestens eine Schwächungszone 52 auf, die z. B. als versetzt zueinander am Umfang des Trägers 48 ausgebildete Radialschlitzung ausgeführt sein kann (vergleiche Radialschlitzung 326 in der Darstellung gemäß Figur 3.1).

Am Umfang des hülsenförmig ausgebildeten Trägers 48 gemäß der Darstellung in Figur 3 befindet sich mindestens ein Aktor 16; innerhalb der Isolation 40 können auch mehrere Aktoren 16 aufgenommen sein. Dabei kann es sich um Kreissegmente eines Aktors 16 oder um mindestens zwei viereckig aufgebaute Piezoaktoren 16 handeln.

Der in Figur 3 dargestellte Träger 48 weist an seinem unteren Ende eine Durchmesseraufweitung auf, die in einem Übergriff ausläuft, der einen Absatz am oberen Ende des hier hülsenförmig ausgebildeten Ventilelementes 44 untergreift. Der Abstand zwischen der Unterseite des ringförmigen Absatzes des hülsenförmig ausgebildeten Ventilelementes 44 und dem am unteren Ende des Trägers 48 ausgebildeten Übergriff ist so gewählt, dass sich ein zweiter Vorhub h₂ einstellt. Der zweite Vorhub h₂ dient dem Ausgleich eventuell verbleibender unterschiedlicher Wärmedehnungen zwischen dem Gehäuse 14, dem Trägermaterial des Trägers 48 und dem Material, aus dem die Piezoschichten 46 gefertigt sind.

Das Schaltventil 42 gemäß der in Figur 3 dargestellten Ausführungsvariante des Kraftstoffinjektors 10 umfasst einen Sitz 300, der in einem Sitzdurchmesser 302 ausgelegt ist. Ein Führungsdurchmesser 304 des hülsenförmig ausgebildeten Ventilelementes 44 entspricht einem Sitzdurchmesser 302 des Sitzes 300. Der Sitz 300 tritt in der Darstellung gemäß Figur 3 zwischen der unteren, gegebenenfalls angeschrägt ausführbaren Stirnseite des hülsenförmig ausgebildeten Ventilelementes 44 und der Oberkante eines stationären Kolbens 316 gebildet. Der stationäre Kolben 316 kann z. B. mittels einer Spannschraube 320, die einen Niederhalter 322 beaufschlagt, im Injektorkörper 12 festgelegt sein. Mit Bezugszeichen 306 ist analog zur in Figur 2 dargestellten zweiten Ausführungsvariante des Kraftstoffinjektors 10 eine Einstellscheibe bezeichnet, über deren Dimensionierung bezüglich der Dicke der zweite Vorhub h₂ definiert werden kann.

Aus der Darstellung gemäß Figur 3 geht hervor, dass der hier hülsenförmig ausgebildete Träger 48 mit Durchmesserweiterung im unteren Bereich und dort angeordnetem Übergriff am Umfang verteilt mindestens einen Durchbruch 310 aufweist und eine Ventilfeder 308 umschließt. Die Ventilfeder 308 stützt sich an einer Führung 314 an der Oberseite des Gehäuses 14 ab und beaufschlagt andererseits eine Stützfläche 312, die ihrerseits auf das hülsenförmig ausgebildete Ventilelement 44 wirkt und dieses in den Sitz 300 drängt.

Der Niederhalter 322, der über die Spannschraube 320 im Injektorkörper 12 des Kraftstoffinjektors 10 festgelegt ist, stützt sich auf der oberen Planseite eines Ventilstücks 318 ab, in dem ein Teil des Ablaufkanals 28 verläuft und in dem die Ablaufdrossel 30 ausgebildet ist. Die Abdichtung des Ventilstücks 318 erfolgt über einen Dichtring 324.

Sind der Führungsdurchmesser 304 und der Sitzdurchmesser 302 identisch ausgebildet, so ergibt sich ein kraftausgeglichenes Schaltventil 42.

Nach Bestromung des mindestens einen innerhalb der Isolation 40 aufgenommenen Aktors 16 über die elektrischen Anschlüsse 18, ziehen sich die Aktorschichten 46 in axiale Richtung, d. h. parallel zur Symmetrieachse des Kraftstoffinjektors zusammen, so dass der mit mindestens einer Schwächungszone 52 versehene Träger 48 ebenfalls kontrahiert wird und nach Überwindung des zweiten Vorhubs h₂ das in der Ausführungsvariante gemäß Figur 3 hülsenförmig ausgebildete Ventilelement 44 aus dem Sitz 300 zieht. Dadurch wird der unterhalb des Sitzes 300 mündende Ablaufkanal 28 geöffnet, so dass eine Steuermenge aus dem Steuerraum 32 innerhalb des Ventilstückes 318 in den niederdruckseitigen Hohlraum 50 abströmt. Abgesteuerte Steuermenge strömt über den mindestens einen Durchbruch 310, der im Bereich der Durchmessererweiterung des hülsenförmig ausgebildeten Trägers 48 ausgebildet ist, dem im Gehäuse 14 angeordneten Leckölablauf 20 zu und von dort in das in Figur 3 nicht dargestellte Kraftstoffreservoir zurück.

Wird die Bestromung des mindestens einen Aktors 16 innerhalb der Isolation 40 hingegen aufgehoben, so wird das Ventilelement 44 durch die Ventilfeder 308, die auf die Stützfläche 312 des hülsenförmig ausgebildeten Ventilelementes 44 wirkt, wieder in den Sitz 300 gestellt. Dadurch wird die Druckentlastung des Steuerraumes 32 beendet. In diesem baut sich aufgrund des unter Systemdruck stehenden Kraftstoffes, der über den Hochdruckzulauf 24 samt mindestens der einen in diesem integrierten Zulaufdrossel 26 wieder in den Steuerraum 32 einströmt, Systemdruck auf, so dass das bevorzugt nadelförmig ausgebildete Einspritzventilglied 34 wieder in seinen Sitz gestellt wird. Dadurch werden die am brennraumseitigen Ende des Kraftstoffinjektors 10 ausgebildeten Einspritzöffnungen geschlossen, so dass die Einspritzung von Kraftstoff in den Brennraum der Verbrennungskraftmaschine beendet wird. Über den vom Hochdruckzulauf 24 abzweigenden Düsenzulauf 36 steht der unter Systemdruck stehende Kraftstoff im Bereich der in Figur 3 nicht dargestellten Einspritzöffnungen am brennraumseitigen Ende des Kraftstoffinjektors 10 an.

Aus der Darstellung gemäß Figur 3.1 geht eine Ansicht des hülsenförmig ausgebildeten Trägers 48 hervor. Dieser weist in seinem unteren Bereich, mit welchem der hülsenförmig ausgebildete Träger 48 den Absatz des hülsenförmig ausgebildeten Ventilelementes 44 gemäß der Darstellung in Figur 3 umschließt, mindestens einen Durchbruch 310 auf. Der Durchbruch 310 dient dem Überströmen von Kraftstoff vom niederdruckseitigen Hohlraum 50 in den Leckölablauf 20. Die mindestens eine am Umfang des hülsenförmig ausgebildeten Trägers 48 ausgebildete Schwächungszone 52 ist in der Darstellung gemäß Figur 3.1 als eine versetzt zueinander angeordnete Schlitze aufweisende Radialschlitzung 326 ausgeführt. Dadurch ist die Steifigkeit des hülsenförmig ausgebildeten Trägers erheblich vermindert, so dass die sich bei Bestromung der Lagen von Piezoschichten 46 in axiale Richtung des Trägers 48 gesehene Kontraktion auf den Träger 48 übertragen lässt und dieser nach Durchlaufen des zweiten Vorhubes h₂- wie in Figur 3 dargestellt - das hülsenförmig ausgebildete Ventilelement 44 aus seinem Sitz 300 aufzieht.

## Patentansprüche

1. Kraftstoffinjektor (10) mit einem mindestens einen Aktor (16) zur Betätigung eines Schaltventiles (42) aufweisenden Gehäuse (14), einem über einen Ablaufkanal (28) druckentlastbaren Steuerraum (32), der über einen Hochdruckzulauf (24) mit einem Systemdruck beaufschlagt ist, **dadurch gekennzeichnet, dass** der mindestens eine Aktor (16) einen mit mindestens einer Schwächungszone (52) versehenen Träger (48) aufweist, an dessen Umfang Lagen von Piezoschichten (46) konzentrisch aufgenommen sind.

2. Kraftstoffinjektor gemäß Anspruch 1, **dadurch gekennzeichnet, dass** die mindestens eine Schwächungszone (52) am Träger (48) in dem Bereich liegt, der von den Lagen von Piezoschichten (46) umschlossen ist.

3. Kraftstoffinjektor gemäß Anspruch 1, **dadurch gekennzeichnet, dass** die mindestens eine Schwächungszone (52) im Material des Trägers (48) als Schlitzung (326) oder als Wellung ausgebildet ist.

4. Kraftstoffinjektor gemäß Anspruch 1, **dadurch gekennzeichnet, dass** das Schaltventil (42) ein kolbenförmig oder glockenförmig ausgeführtes Ventilelement (44) umfasst, welches einen Führungsdurchmesser (122, 218, 304) aufweist, der einem Sitzdurchmesser (120, 216, 302) eines Sitzes (116, 220, 300) des Schaltventiles (42) entspricht.

5. Kraftstoffinjektor gemäß Anspruch 1, **dadurch gekennzeichnet, dass** der Träger (48) im Wesentlichen hülsenförmig ausgeführt ist und sich am Gehäuse (14) oder an einem durch ein hydraulisches Polster beaufschlagten Ausgleichskolben (104) oder an einem Gehäusezapfen (222) abstützt.

6. Kraftstoffinjektor gemäß Anspruch 1, **dadurch gekennzeichnet, dass** die Wärmeausdehnungskoeffizienten des Materials des Gehäuses (14), des Trägers (48) und/oder des Piezoaktors (16) im Wesentlichen einander entsprechen.

7. Kraftstoffinjektor gemäß Anspruch 1, **dadurch gekennzeichnet, dass** zwischen dem Träger (48) und dem Ventilelement (44) ein erster Vorhub h₁ durch eine in einer Ausnehmung (202) des Ventilelementes (44) bewegbare Scheibe (200) oder ein zweiter Vorhub h₂ zwischen einem Übergriff des Trägers (48) und dem Ventilelement (44) ausgeführt ist.

8. Kraftstoffinjektor gemäß Anspruch 1, **dadurch gekennzeichnet, dass** der mindestens eine Aktor (16) von einer Isolation (40) umschlossen ist und in einem Niederdruckbereich (50) des Kraftstoffinjektors (10) angeordnet ist.

9. Kraftstoffinjektor gemäß Anspruch 1, **dadurch gekennzeichnet, dass** die mindestens eine Schwächungszone (52) am Träger (48) als Radialschlitzung (326), als Längsschlitzung, als Wellung oder durch axial versetzt oder einander gegenüberliegend angeordnete Nuten (124, 126; 224, 226) an Innen- und Außenseite des Trägers (48) ausgebildet ist.

10. Kraftstoffinjektor gemäß Anspruch 1, **dadurch gekennzeichnet, dass** das Ventilelement (44) durch eine sich am Aktor (16, 212) abstützende Feder (214) oder eine am Gehäuse (14) abstützende Feder (308), die über eine Stützfläche (312) auf das Ventilelement (44) wirkt, beaufschlagt ist.

11. Kraftstoffinjektor gemäß Anspruch 1, **dadurch gekennzeichnet, dass** der Träger (48) unterhalb des Aufnahmebereiches für die Lagen von Piezoschichten (46) mindestens einen Durchbruch (310) zum Abfluss von Kraftstoff in den Niederdruckbereich (50) aufweist.
